# EUROPEAN PATENT APPLICATION

(11) **EP 1 202 329 A2**
(43) Date of publication of application: **02.05.2002**
(21) Application number: 01308908.1
(22) Date of filing: 19.10.2001
(51) Int. Cl.: H01L 21/00, G03F 7/20

(54) **Mask Restraining method and apparatus**

(30) Priority: 31.10.2000 US 703100
(71) Applicant: THE BOC GROUP, INC., Murray Hill, New Providence, New Jersey 07974-2082 (US)
(72) Inventor: Ramsey, Bruce Gordon, Novato, California 94945 (US)
(74) Representative: Bousfield, Roger James

(57) **Abstract**

An apparatus and method for restraining a shadow mask against a work piece using attractive forces. Specific embodiments in which the shadow mask is restrained against a substrate using both magnetic forces and electrostatic forces are described. The invention allows for the use of masks that would otherwise be difficult to flatten against a substrate. The invention has the advantage of being useful for much larger shadow masks than previously possible, and allowing for masking of large substrates that are incompatible with wet chemical processing.

## Description

The invention relates to a method and apparatus for restraining a mask on a substrate with an attractive force. More particularly, the invention relates to a method and apparatus for providing magnetic or electrostatic forces to a shadow mask thereby restraining the mask during substrate processing.

Many manufacturing steps require the ability to deposit, etch, or generally process, a work piece according to specified positions or patterns. Examples include, but are not limited to printing, etching, and various semiconductor substrate-manufacturing steps. For masking of semiconductor substrates, a mask having open and closed areas is provided over a work piece, or substrate, which are then placed together in an environment that promotes processing of substrate areas beneath the open areas. High precision coating operations require that patterns, and thus masks, be positioned and aligned accurately over the substrate. In addition, masks should also be close to the work piece so that the edges of the processed area are well defined.

One example of a high precision masking operation is in the manufacturing of semiconductors. Commonly used semiconductor masking techniques include photolithography, which uses wet chemistry to form the mask directly onto the substrate, and shadow masks, which are separate, sheet-like structures that are physically placed over the substrate. Photolithography is capable of achieving the high precision and alignment required of many semiconductor processes at the expense of additional, expensive processing steps. Specifically, photolithographic masks are formed by transferring the pattern from a photomask onto the substrate by supplying a photoresist to the substrate, illuminating photoresist-covered substrate through a photomask to harden exposed portions of the photoresist, and removing the unexposed photoresist through wet chemical processing. The mask pattern is then removed after processing through additional wet chemistry steps. In addition to requiring several processing steps to form a mask, it is important that the substrate and any other materials on the substrate not have adverse reactions with the wet chemistry solutions necessary to form and remove the mask.

Shadow masks include a sheet of material that is placed between the substrate and coating source. Open areas in the shadow mask allow coating material or etchants to contact the substrate, while closed areas prevent vapours from contacting the substrate. The coating of small features using a shadow mask requires a thin mask, preferably in contact with the substrate. Unlike photolithographic masks, shadow masks are reusable and require no additional processing steps. For precise coatings, the shadow mask should be thin and must be held in a manner that allows for accurate alignment with the substrate - preferably against the substrate. For larger substrates with accurate alignment requirements, shadow mask performance may not be adequate. A large, thin mask will bow under the influence of gravity, and may crinkle or become otherwise deformed, making it difficult accurately to locate the mask in relation to the substrate. With an evaporative source, for example, the substrate is above the source, and a thin mask will have a catenary shape that bows the shadow mask away from the substrate.

Advanced semiconductor manufacturing masking requirements, especially for the processing of larger substrates and of organic materials, are not easily addressed using prior art photolithography or shadow masking. Various types of flat panel displays, for example, are fabricated using semiconductor methods on a much larger surface area. Organic light emitting diodes, which are fabricated for large, flat panel displays, are incompatible with many chemical solutions used for photolithography. Even without these compatibility issues, the equipment necessary to mask using photolithography may be complex and expensive. While using a shadow mask could address both of these problems, current shadow mask technology does not allow for accurate alignment of small features over large substrates.

In summary, shadow masks for semiconductor manufacturing are potentially simpler and less expensive than rival photolithographic techniques, and have the advantage of being compatible with a larger variety of substrate and deposited materials. The use of prior art shadow masks is limited by lack of accuracy, especially for large masks. In view of the limitations in the masking arts, there exists a need for a masking technology that allows for accurate alignment of small features over large substrates without the use of wet chemistry, and preferably with no processing steps in addition to the etching or deposition steps for which the mask is required.

In accordance with one aspect of the invention, there is provided a mechanical mechanism for masking a substrate comprising a mask; and an assembly for inducing an attractive force on the mask towards the substrate, wherein the attractive force includes an electromagnetic force, and where the substrate is positioned between the mask and the assembly.

In accordance with another aspect of the invention, there is provided a method for masking a substrate with a mask comprising providing an attractive force on the mask towards the substrate, wherein the attractive force includes an electromagnetic force

In accordance with a further aspect of the invention, there is provided a method for masking a substrate for processing with a mask having a first position that is insufficient to contact the substrate, the method comprising increasing the strength of an attractive force sufficient to force a portion of the mask from the first position into a second position that contacts the substrate, where the attractive force includes an electromagnetic force; and after processing, decreasing the strength of the attractive force to allow the mask to at least partially return to the first position.

The invention therefore includes methods and apparatus for providing an attractive force through a substrate to hold a shadow mask and substrate together during processing. The attractive force of the invention must generally include forces induced on the mask in a direction towards the substrate where the forces result from electromagnetic fields, either statically or dynamically. Examples of attractive forces include, but are not limited to, appropriately configured magnetic forces, electrostatic forces, eddy currents, or combinations thereof. Providing such an attractive force overcomes several of the limitations of prior art shadow masks and allows the inventive mask to be used in high precision masking operations. In addition to allowing for the accurate use of a shadow mask under conditions not heretofore possible, the invention can also be used for substrates and deposited material that may not be compatible with photolithographic wet chemistry solutions.

One aspect of the invention is the use of an attractive force to conform a flexible mask against a substrate. It is preferred that the attractive force be adjustable between at least two states: a first state where the mask is not in contact with the substrate, and a second state in where the mask is in contact with the substrate. In one embodiment the attractive force is a magnetic force that is generated by a magnet positioned on one side of a substrate, and the mask, which has a magnetic portion, is positioned on the opposite side of the substrate. Examples of magnets that can produce adjustable forces on a mask include, but are not limited to, an electronically adjustable electromagnet, or a movable permanent magnet. The magnetic force attracts the mask through the substrate, supplying a force to hold the mask and substrate together. A tensioning device can alternatively be used to restrain the mask in a substantially flat shape.

In an alternative embodiment that is useful for non-conducting substrates, the positioning force is an electrostatic force generated by an electrode on one side of a substrate, and the mask, which includes a conducting portion, is positioned on the opposite side of the substrate. The electrostatic force permeates the non-conductive substrate and attracts the conductive mask to the substrate.

It is another aspect of the invention to position a shadow mask over a substrate with methods and apparatus that can be used in a variety of orientations. In one embodiment, gravity pulls the mask towards the substrate. In an alternative embodiment, gravity pulls the mask away from the substrate. Tension within the mask, optionally augmented with an additional tensioning mechanism, substantially flattens the mask. An adjustable attractive force is provided to attract the mask onto the substrate surface, providing for accurate positioning of shadow masks under conditions not possible in the prior art.

It is yet another aspect of the invention to process a substrate covered by a mask by
1) increasing the strength of a positioning force to draw the mask onto the substrate,
2) processing the substrate, and 3) decreasing the strength of said positioning force to allow said mask to move away from the substrate.

It is another aspect of the invention accurately to mask a semiconductor substrate using techniques that are compatible with prior art processing steps, without requiring additional processing. Additionally, it is an aspect of the invention to mask a semiconductor substrate using techniques that are compatible with a variety of materials, such as organic materials.

For a better understanding of the invention, reference will now be made, by way of exemplification only, to the accompanying drawings, in which:
Figure 1 is a side view of an embodiment of the invention showing the mask positioned on the substrate.
Figure 2A is a top view of an embodiment of the invention showing the shadow mask.
Figure 2B is a top view of an alternative shadow mask embodiment.
Figure 3A is a side view showing the forces on a mask positioned below the substrate prior to the application of an attractive force.
Figure 3B is a side view showing the forces on a mask positioned below the substrate during the application of an attractive force.
Figure 4A is a side view showing the forces on a mask positioned above the substrate prior to the application of an attractive force.
Figure 4B is a side view showing the forces on a mask positioned above the substrate during the application of an attractive force.
Figure 5A is a side view of a first embodiment utilising a permanent magnet, with the embodiment configured for loading a substrate.
Figure 5B is a side view of a first embodiment utilising a permanent magnet, with substrate moved into position for processing.
Figure 5C is a side view of a first embodiment utilising a permanent magnet, with the magnet moved into position for forcing the mask onto the substrate.
Figure 6A is a side view of a second embodiment utilising an electromagnet, with the embodiment configured for loading a substrate.
Figure 6B is a side view of a second embodiment utilising an electromagnet, with substrate moved into position for processing.
Figure 6C is a side view of a second embodiment utilising an electromagnet, with the electromagnet energized to force the mask onto the substrate.
Figure 7A is a side view of a third embodiment utilising an electrostatic attractive force, with the embodiment configured for loading a substrate.
Figure 7B is a side view of a third embodiment utilising an electrostatic attractive force, with substrate moved into position for processing.
Figure 7C is a side view of a third embodiment utilising an electrostatic attractive force, with the electromagnet energized to force the mask onto the substrate.

The invention provides a method and apparatus for controlling a shadow mask according to the tension and a controllable attractive force on a mask. Specifically, the attractive force acts on and holds, or restrains, the mask against a substrate for processing. There are many attractive forces that can achieve the various aspects of the invention. For convenience, the invention will be described in terms of a general attractive force, followed by the specific embodiments of a magnetic force and an electrostatic force.

The invention will also be described in terms of a deposition process, for example of using deposition apparatus disclosed in U S Patent 4,971,674 or US Patent 4,632,059. This specific application of the invention is not meant to limit the scope of the invention, which can be applied to other processes, including but not limited to masking a work piece for coating, etching, or any other processes that are applied in a pattern to a work piece. The types of work pieces include, but are not limited to, flat panel displays, semiconductor substrates, ceramic printed wiring chip carriers, ceramic hybrid substrates, ball grid array carriers, printed wiring boards, flexible printed circuit boards, and screen printing. In addition, the invention is not limited as to the pressure at which processing occurs.

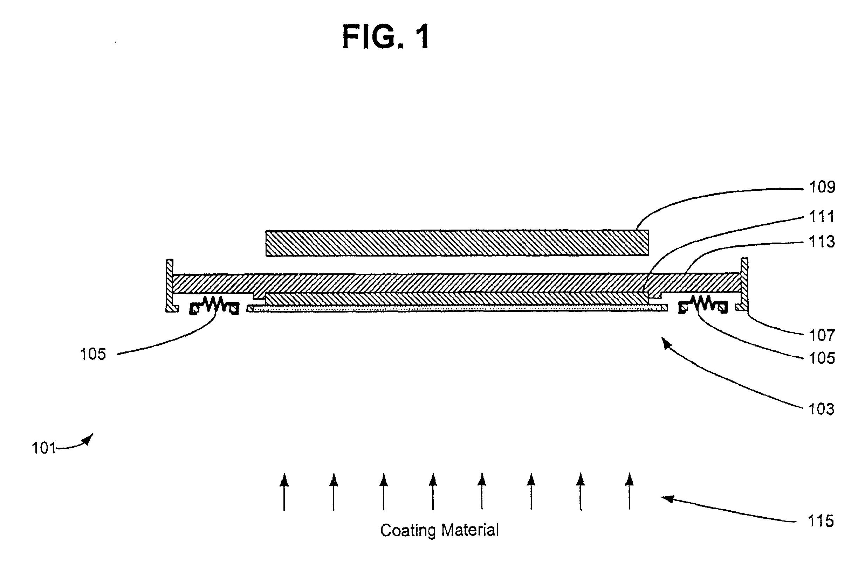

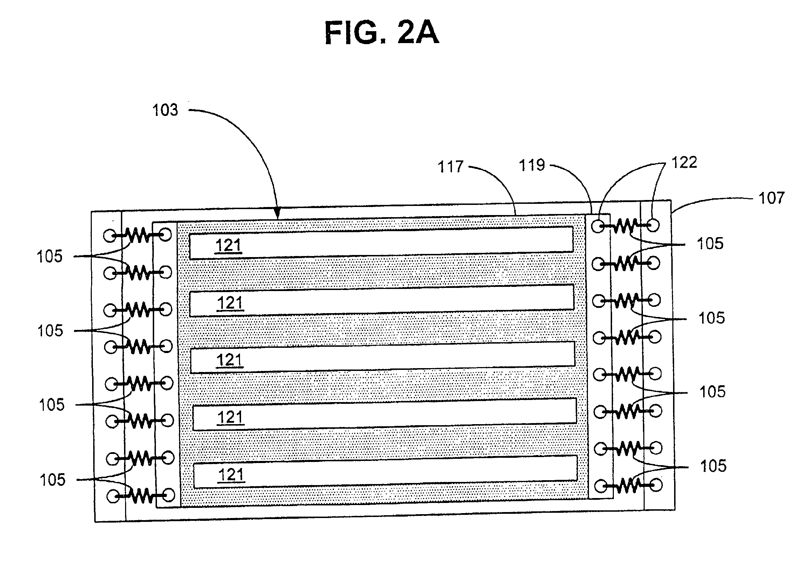

Figure 1 is a side view of an embodiment of the invention showing a shadow mask 103 and positioned on a substrate 111 during a coating operation, and Figure 2A is a top view of a shadow mask of the invention. A stream of coating material 115 approaches a masking apparatus 101 that contains the substrate 111. The masking apparatus 101 includes a frame 107 having springs 105 to provide tension to the mask 103, a substrate holder 113, and an assembly 109 for inducing an attractive force on an attractive portion 117 towards the assembly 109, and hence towards the substrate 111. The springs 105 are connected to the frame 107 and the mask 103 through holes 122. The tension induced by springs 105 allows the mask 103 to remain substantially flat, and allows coating material 115 to be deposited accurately on the substrate 111 through mask openings 121.

In general, the attractive force can be magnetic, electrostatic, or some combination thereof. The attractive portion 117 and the assembly 109 are chosen to cooperate and produce the attractive force on the mask 103 towards the substrate 111. In addition to the attractive portion 117, the mask 103 also includes a surrounding portion 119 that is not necessarily attracted to the assembly 109. The attractive force may be variable, ranging from a first attractive force, or holding force, sufficient to hold the mask 103 against the substrate 111 to a second attractive force insufficient to hold the mask against the substrate. The application of the first attractive force allows for processing of the masked substrate, while the application of the second attractive force allows for positioning of the mask, separation of substrate from the substrate holder, or other operations that can be accomplished in the absence of a mask holding force.

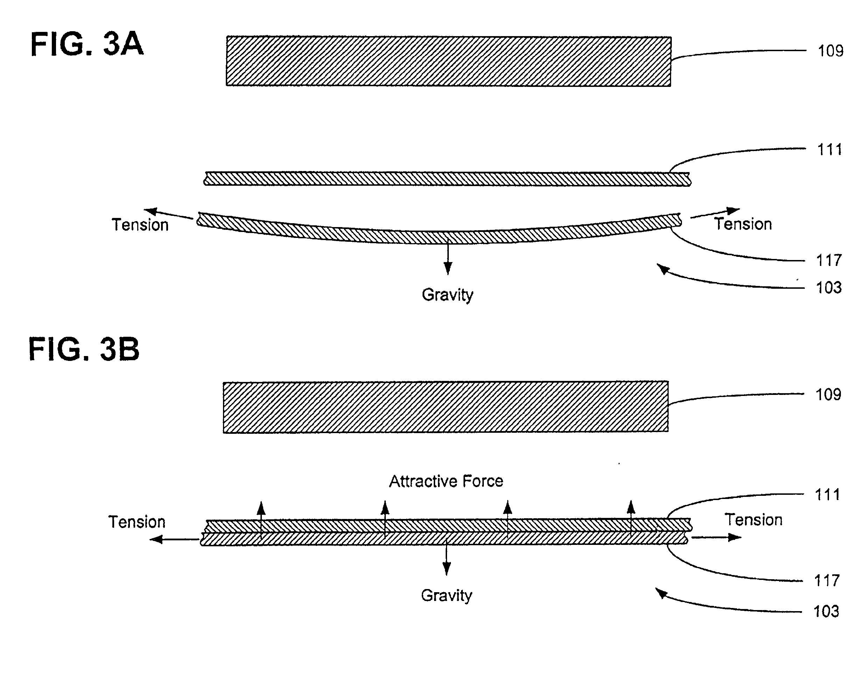

Figures 3A and 3B are side views showing the forces on a mask located below the substrate, prior to and during the application of an attractive force, respectively. This orientation would be used, for example, in an evaporative coating apparatus, where the coating material 115 is necessarily directed upwards against gravity, and the coating surfaces are directed downwards. Figure 3A shows the forces on the attractive portion 117 in the absence of attractive forces. There are two forces acting on the attractive portion 117 of mask 103: a tension force and a gravitational force. Tension in the mask 103 results from gravity forcing the edge-held mask into a catenary. For some masks, this tension is sufficient to flatten the mask, and the additional tension provided by and springs 105 of Figure 2A can be replaced with other connecting devices or mechanisms, such as welds, screws or rivets. In an additional embodiment, a non-rigid frame 107 can provide a spring force to the mask 103 through attachment points 129. The gravitational force away from the substrate 111 results from the placement of the mask 103 below the substrate 111. Without an attractive force, the mask 103 assumes a catenary shape (greatly exaggerated in Figure 3A), bowing away from the substrate 111.

If the attractive force is non-zero, but less than the gravitational attraction, the resulting forces will cause the mask 103 to bow into a modified and less pronounced catenary, as shown in Figure 3B. If the attractive force is increased to a point equal to or greater than the gravitational attraction, the attractive portion 117 is pulled onto the substrate 111 in a position suitable for masking the substrate.

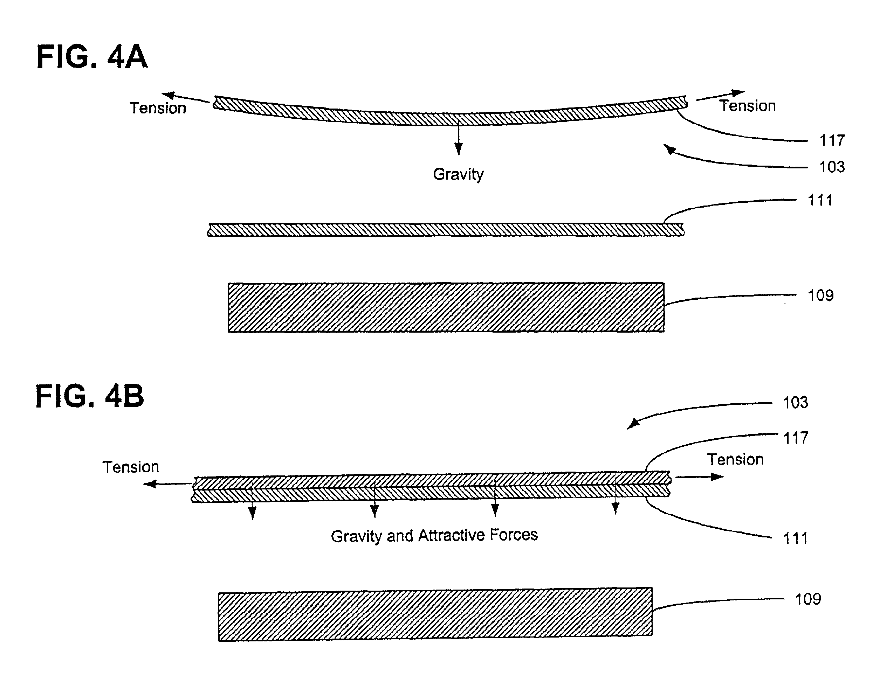

An alternate orientation having the mask above the substrate is shown with and without an attractive force, in Figures 4A and B respectively. In this orientation, tension provides a force to flatten the mask. Since gravity and attractive forces are in the same direction, the attractive force needs to overcome the force of tension that is perpendicular to the mask 103 to permit the mask 103 to conform to substrate 111, which may not be flat.

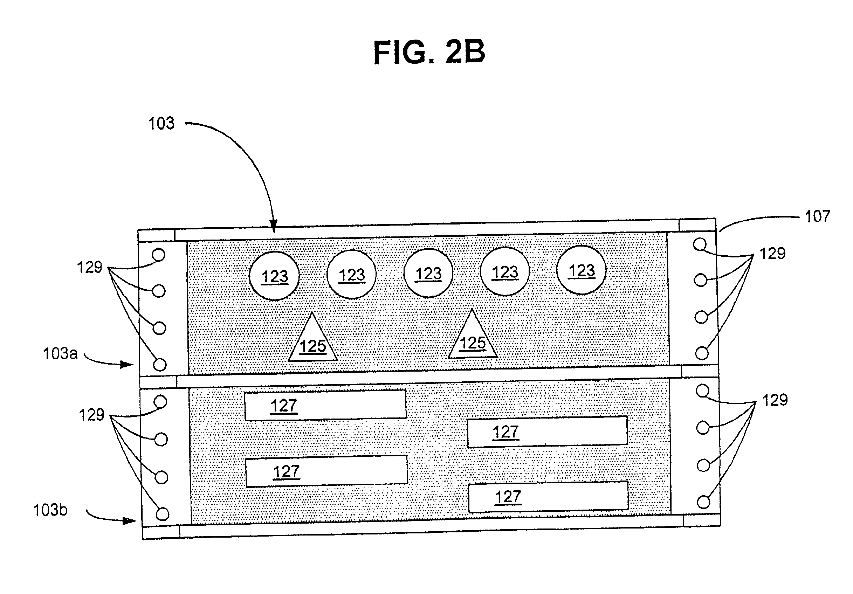

Alternatively, the invention includes the use several mask configurations, as shown in Figure 2B. The mask 103 consists of a first mask 103a and second mask 103b. The two masks are arranged so they may be held along portions not masked. The alternative embodiment has attachment of the mask 103 to the frame 107 by means of attachment points 129 positioned about the edge of the mask. Alternative masks 103, as shown in Figure 2B also include staggered arrangements of open areas 127, as well as circular areas 123, triangular areas 125, more than two masks (not shown) and any shape and/or arrangement of open areas that permit flattening through tension in mask.

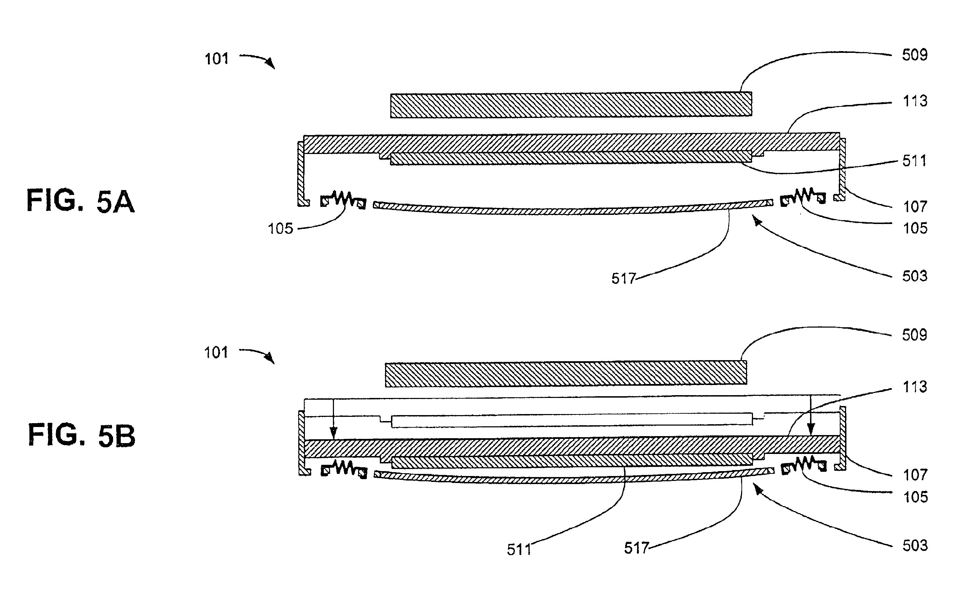

Three specific magnetic embodiments of the invention are now described. The first two embodiments use magnetic attraction to restrain the mask. Figures 5A-C are side views of a first embodiment utilising magnetic attraction. In the first embodiment, the assembly 109 is a permanent magnet 509 that can move towards and away from the frame 107, a mask 503 having an attractive magnetic portion 517 that is attracted to the permanent magnet 509, and the substrate holder 113 that can move perpendicular to a substrate 511 within the frame 107. Magnetically attractive materials for attractive portion 117 include, but are not limited to alnico, samarim-cobalt and neodymium.

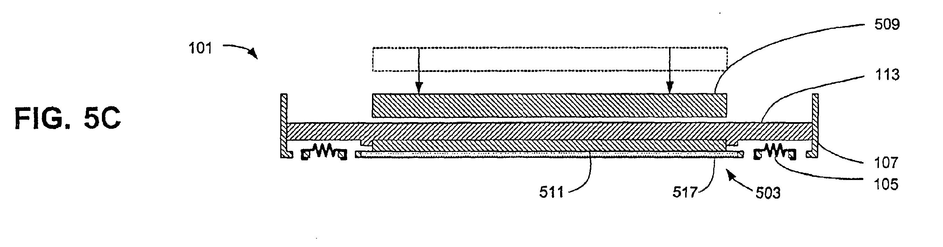

Figures 5A-C represent three consecutive configurations for loading a substrate 511 for processing. Specifically, Figure 5A shows the configuration for loading the substrate 511 into the substrate holder 113, with the permanent magnet 509 and the substrate holder 113 furthest from the mask 503. Figure 5B shows the configuration where the substrate holder 113 is moved towards the mask 503 to positioning the substrate for coating. In the configurations of Figure 5A and 5B the attractive force is insufficient to cause the mask 503 to contact the substrate 511. Figure 5C shows the configuration for moving an aligned mask onto the substrate by moving the permanent magnet towards the substrate. With the magnet so placed, the attractive force is sufficient to cause the mask 503 to contact the substrate 511.

Alignment of the mask 503 on the substrate 511 is not shown in Figure 5, but can include sensing the relative position between the mask and substrate and mechanically adjusting the alignment using sensors and actuators that are known in the art. After processing the substrate 511, the permanent magnet 509 is moved back to the configuration of Figure 5B, the substrate holder 113 is moved back to the configuration of Figure 5A, and the substrate is removed from the substrate holder.

The magnetic attraction of magnetic portion 517 towards substrate 511 is reduced by increasing the separation between the magnetic portion and the permanent magnet 509, but is always present at some level. The magnetic portion 517 will thus have some magnetic attraction in the direction opposite the direction of gravity, resulting in a modified catenary.

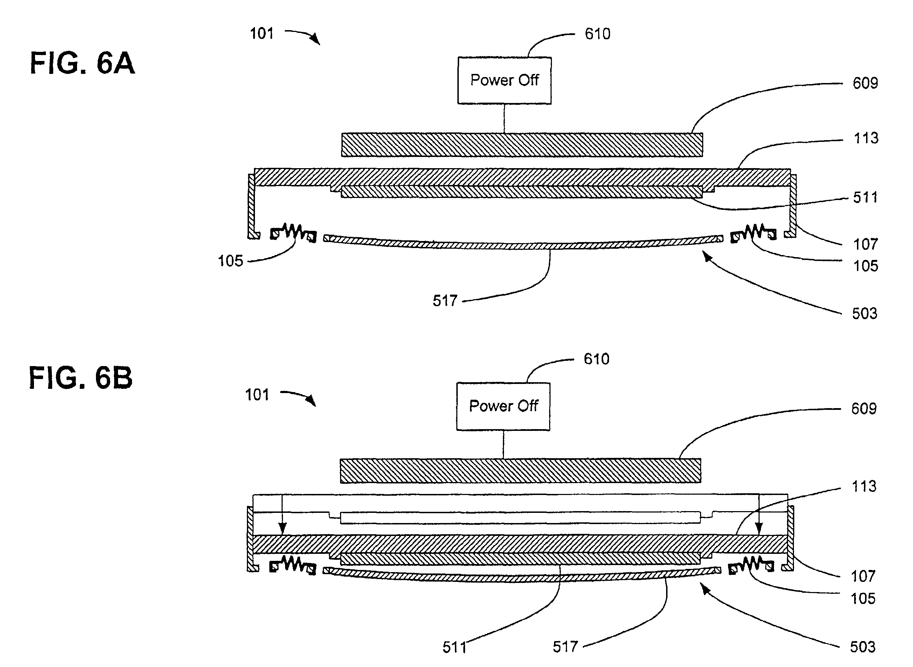

Figures 6A-C are side views of a second embodiment utilising an electromagnet 609. The second embodiment includes the substrate holder 113 that can move within the frame 107, and the electromagnet 609 that has a strength that is adjustable through a power supply 610. The power supply 610 is shown as having an "off position," producing little or no magnetic attraction to the magnetic portion 517, and an "on position," producing at least enough magnetic attraction with the magnetic portion to overcome gravity. Alternatively, the various aspects of the invention can be achieved with more than two power settings, including variable power settings, and that the settings can change during substrate loading, during processing, and during substrate removal.

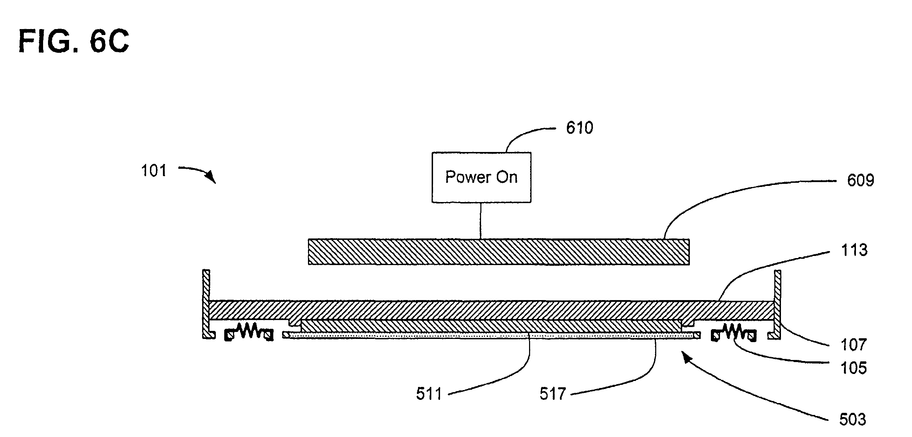

Figures 6A-C represent three consecutive configurations for loading a substrate 511, moving the substrate into position for coating, and increasing the magnetic force on the mask 503 towards the substrate. Specifically, Figure 6A shows the configuration for loading the substrate 511 into the substrate holder 113, with the substrate holder 113 furthest from the mask 503. Figure 6B shows the configuration where the substrate holder 113 is moved towards the mask 503 to position the substrate for coating. The attractive force in the configurations of Figures 6A and 6B is insufficient to cause the mask 503 to contact the substrate 511. Figure 6C shows the configuration where the electromagnet 609 is powered to increase the force of the magnetic portion 517 towards the substrate. With the electromagnet so energised, the mask 503 is brought into contact with substrate 511. After processing substrate 511, power supply 610 is turned off, as in Figure 6B, the substrate holder 113 is moved back to the configuration of Figure 6A, and the substrate is removed from the substrate holder.

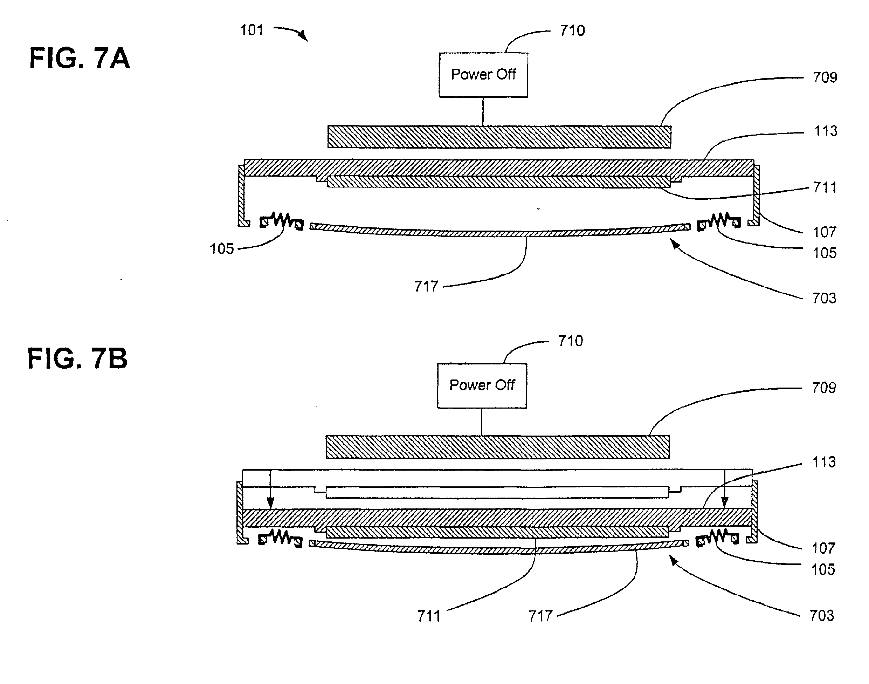

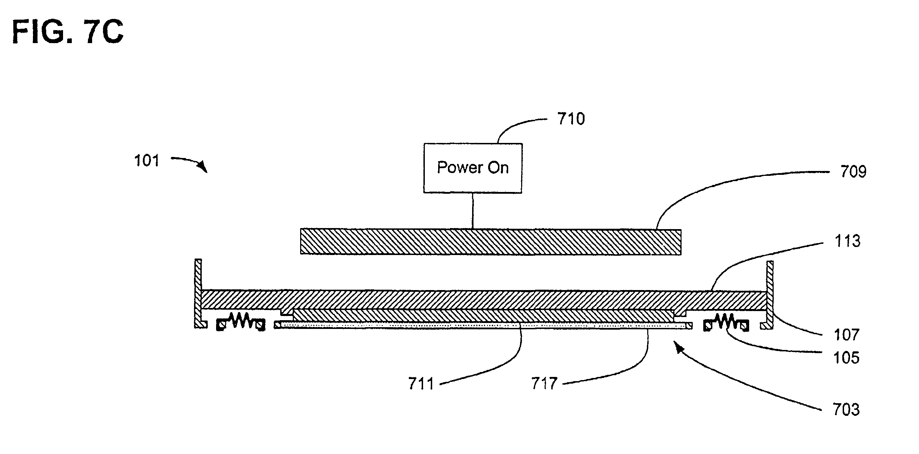

A third embodiment, in which electrostatic attractive forces provide a mask holding force, will now be described with reference to Figures 7A-C. The assembly 109 of Figure 1 is adapted to produce an electrostatic field through an electrode 709 that can be powered through a power supply 710 to produce a variable attractive force described previously. Specifically, the third embodiment includes an essentially non-conductive substrate 711, a mask 703 having an electrostatic attractive portion 717, an electrode 709, and a power supply 710 adapted to power electrode 709. The remainder of the components is similar to those of the second embodiment. It is important that a substrate 711 is non-conductive or has a sufficiently poor conductivity to permit the electrostatic field to extend through the substrate to the attractive portion 717 of mask 703. Appropriate conductive materials for the attractive portion include, but are not limited to copper, aluminium, and other conducting materials that are compatible with the masking environment.

Figures 7A-C represent three consecutive configurations for loading a substrate 711, moving the substrate into position for coating, and increasing the electrostatic force on the attractive portion 717 towards the substrate. The discussion of Figures 7A-C substantially follow that of Figures 6A-C, where electrostatic forces are used in place of magnetic forces for attracting the mask 703 and contacting the mask against substrate 711. Specifically, the movement of the substrate support 113 and powering of the electrode 709 to attract mask 503 follow the same sequence of events for masking the substrate.

The methods and apparatus of the invention can be practised using attractive forces supplied by combinations of permanent magnets and electromagnets, or by combinations of magnetic forces and electrostatic forces. Additionally, the masks and substrates are not limited to orientation relative to gravity, and thus may be horizontal, vertical or have other orientations.

## Claims

1. A mechanism for masking a substrate comprising:
a mask; and
an assembly for inducing an attractive force on the mask towards the substrate,
wherein the attractive force includes an electromagnetic force, and where the substrate is positioned between the mask and the assembly.

2. A mechanism according to Claim 1 in which the attractive force is a magnetic force, wherein the assembly includes a magnet, and wherein the mask includes a magnetic portion.

3. A mechanism according to Claim 1 in which the attractive force is an electrostatic force, the assembly includes an electrode, and the mask includes an electrically conducting portion.

4. A mechanism according to any preceding claim in which the mask includes two or more separate masks.

5. A mechanism according to any preceding claim, further comprising a tensioning mechanism for substantially flattening the mask.

6. A mechanism according to Claim 5, further comprising a frame to hold the mask, and wherein the tensioning mechanism includes one or more springs connecting the mask and the frame.

7. A mechanism according to any preceding claim, further comprising a holder to restrain the substrate during masking.

8. A mechanism according to any preceding claim in which the attractive force is an adjustable attractive force variable between:
a first attractive force sufficient to substantially contact the mask with the substrate; and
a second attractive force insufficient to contact the mask with the substrate.

9. A mechanism according to Claim 8 in which the mask is positioned below the substrate such that one of the first attractive force or the second attractive force opposes gravity.

10. A mechanism according to Claim 8 or Claim 9 in which the attractive force is a magnetic force, wherein the mask includes a magnetic portion, and wherein the assembly includes a permanent magnet adjustably movable in a direction perpendicular to the frame for producing the adjustable magnetic force.

11. A mechanism according to any one of Claims 8, 9 or 10 in which the attractive force is a magnetic force, the mask includes a magnetic portion, and the assembly includes an electromagnet having an adjustable strength for producing the adjustable magnetic force.

12. A mechanism according to Claim 8 in which the attractive force is an electrostatic force, the mask includes an electrically conducting portion, the attractive force is a magnetic force, and the assembly includes an electrode having an adjustable strength for producing the adjustable electrostatic force.

13. A method for masking a substrate with a mask comprising providing an attractive force on the mask towards the substrate, wherein the attractive force includes an electromagnetic force.

14. A method according to Claim 13, further comprising providing a tension force on the mask, wherein the tension force substantially flattens the mask.

15. A method for masking a substrate for processing with a mask having a first position that is insufficient to contact the substrate, the method comprising:
increasing the strength of an attractive force sufficient to force a portion of the mask from the first position into a second position that contacts the substrate, where the attractive force includes an electromagnetic force; and
after processing, decreasing the strength of the attractive force to allow the mask to at least partially return to the first position.

16. A method according to any one of Claims 13 to 15 in which the attractive force is a magnetic force, and wherein the mask includes a magnetic portion.

17. A method according to any one of Claims 13 to 15 in which the attractive force is an electrostatic force, and where the mask includes an electrically conducting portion.

18. A method according to any one of Claims 15 to 17, further comprising tensioning the mask by either gravity force or spring force.
